# EUROPEAN PATENT APPLICATION

(11) **EP 1 548 825 A2**
(43) Date of publication of application: **29.06.2005**
(21) Application number: 04029700.4
(22) Date of filing: 15.12.2004
(51) Int. Cl.: H01L 23/498

(54) **Semiconductor device, manufacturing method thereof and electronic equipment**

(30) Priority: 24.12.2003 JP 2003425987
(71) Applicant: SEIKO EPSON CORPORATION, Shinjuku-ku, Tokyo 163-0811 (JP)
(72) Inventor: Kori, Toshiaki, Suwa-shi Nagano-ken 392-8502 (JP)
(74) Representative: HOFFMANN - EITLE

(57) **Abstract**

The invention relates to providing a semiconductor device in which a connecting terminal of a chip is prevented from being come off from a land of a circuit board. A semiconductor device includes a substrate 3 on which a plurality of first terminals 31 are formed and a chip 2 having a second terminal 21 electrically coupled to astride at least two first terminals 31 out of the plurality of the first terminals 31.

## Description

### [Detailed Description]

### [Field of the Invention]

The present invention relates to a semiconductor device, a manufacturing method thereof and electronic equipment.

### [Description of the Related Art]

When a chip having connecting terminals that are arrayed such as Ball Grid Array (BGA) and Chip Size Package (CSP) is mounted on a circuit board, a single terminal of the chip is coupled to a single land out of a plurality of lands formed on the circuit board.

An edge of such mounted chip receives a strong stress caused by heat shock. Therefore, there is a problem that the connecting terminal located in the edge region of the chip could come off from the land of the circuit board.

In order to solve such problem, Japanese Unexamined Patent Publication No. 9-45810 discloses a technique that prevents the connecting terminal from coming off from the land with the heat shock by making the connecting terminal located in the edge region larger in size and improving a strength of the connecting terminal.

### [Patent Document 1]

Japanese Unexamined Patent Publication No. 9-45810

### [Disclosure of the Invention]

### [Problem to Be Solved]

As is generally known, connecting terminals are so closely arranged in such chip as BGA and CSP that it is hard to make the connecting terminal located in the edge region much larger in size. Therefore, it is difficult to acquire tolerance against the stress caused by the heat shock and the like.

The present invention has been developed in consideration of the above-mentioned problem, and intended to provide a semiconductor device in which a connecting terminal of a chip is prevented from being come off from a land of a circuit board.

### [Means to Solve the Problem]

A semiconductor device of the present invention includes a substrate on which a plurality of first terminals are formed and a chip having a second terminal electrically coupled to astride at least two first terminals out of the plurality of the first terminals. Here, the chip includes an integrated circuit and a package of the integrated circuit.

According to the semiconductor device of the present invention, the chip has the second terminal electrically coupled to astride at least two first terminals out of the plurality of the first terminals. Therefore, a contact area of the chip and the circuit board becomes large and it can improve tolerance against the stress caused by the heat shock and the like. Accordingly, the semiconductor device of the present invention can improve strength and it can prevent connecting terminals of the chip from coming off from lands of the circuit substrate.

In the semiconductor device, the second terminal is preferably provided in an edge region of a predetermined face of the chip. In this way, the second terminal that has a large contact area with the circuit substrate is provided on the edge region of the predetermined face of the chip. This can prevent the connecting terminals, which is placed on the edge region where is most venerable to the stress caused by the heat shock, from being come off from the lands of the circuit substrate.

In the semiconductor device, the second terminal may be provided at each comer of a predetermined rectangular face of the chip. In this way, the second terminal that has the large contact area with the circuit substrate is provided at the each comer of the predetermined rectangular face of the chip. This can prevent the connecting terminals, which is placed at the each comer where is most venerable to the stress caused by the heat shock in the edge region of the chip, from being come off from the lands of the circuit substrate.

In the semiconductor device, a third terminal that is smaller in size than that of the second terminal and provided in a plural number may be formed, the second terminal may be provided in a plural number on the predetermined face of the chip and the plurality of the second terminals and the plurality of the third terminals may have a substantially same height from the predetermined face.
In this way, for example, the chip can be easily mounted because a bottom edge of the second terminal placed in the edge region of the chip and a bottom edge of the third terminal placed at a center of the chip are substantially the same.

In the semiconductor device, the second terminal may provided in the plural number and each second terminal may have a different shape.
In this way, the shape of the second terminal can be changed according to a position of the chip.

In the semiconductor device, each of the plurality of the first terminals may be substantially same in size.

A method of manufacturing a semiconductor device of first aspect of the present invention includes a step of forming a plurality of first terminals on a substrate, a step of forming a second terminal on a chip so as to be electrically connectable to astride at least two first terminals out of the plurality of the first terminals and a step of coupling the first terminal and the second terminal electrically.

A method of manufacturing a semiconductor device of second aspect of the present invention includes a step of forming a plurality of first terminals on a substrate, a step of forming a plurality of third terminals on a chip such that each of the third terminals is electrically connectable to each of the first terminals, a step of coupling the first terminal and the third terminal electrically and a step of forming a second terminal that is electrically coupled to astride at least two first terminals by filling a gap between the third terminals with a conductive material.

As describe above, according to the method of manufacturing a semiconductor device, the second terminal on the chip so as to be electrically connectable to astride at least two first terminals out of the plurality of the first terminals, and then the first terminal and the second terminal may be electrically coupled. Or the plurality of third terminals may be formed on the chip such that each of the third terminals is electrically connectable to each of the first terminals, and then the second terminal that is electrically coupled to astride at least two first terminals may be formed by filling a gap between the third terminals with a conductive material after the first terminal and the third terminal are electrically coupled.

According to the method of manufacturing a semiconductor device, the contact area between the chip and the circuit substrate can be expanded and it makes it possible to manufacture the semiconductor device whose tolerance against the stress caused by the heat shock and the like is improved.

An electronic equipment according to the present invention includes the above described semiconductor device.
In this way, a reliability of the electronic equipment is improved because the electronic equipment according to the present invention has the semiconductor device in which the connecting terminal of the chip is prevented from being come off from a land of the circuit substrate.

### [Brief Description of the Drawings]

[FIG. 1] FIG. 1 is a side view of a semiconductor device 1 showing an example of the present invention.
[FIG. 2] FIG. 2 is a view looking at a chip 2 shown in FIG. 1 from its underside.
[FIG. 3] FIG. 3 shows a manufacturing method of the semiconductor device according to a first embodiment.
[FIG. 4] FIG. 4 shows the manufacturing method of the semiconductor device according to the first embodiment.
[FIG. 5] FIG. 5 shows an example of electronic equipment having the semiconductor device according to the first embodiment.
[FIG. 6] FIG. 6 shows a manufacturing method of the semiconductor device according to a second embodiment.
[FIG. 7] FIG. 7 shows a manufacturing method of the semiconductor device according to the second embodiment.

### [Description of the Preferred Embodiments]

Embodiments of a semiconductor device, a manufacturing method thereof and electronic equipment according to the present invention will now be described in detail with reference to the accompanying drawings. In the figures, a scale size may be different in each member in order to make it recognizable.

### (First embodiment)

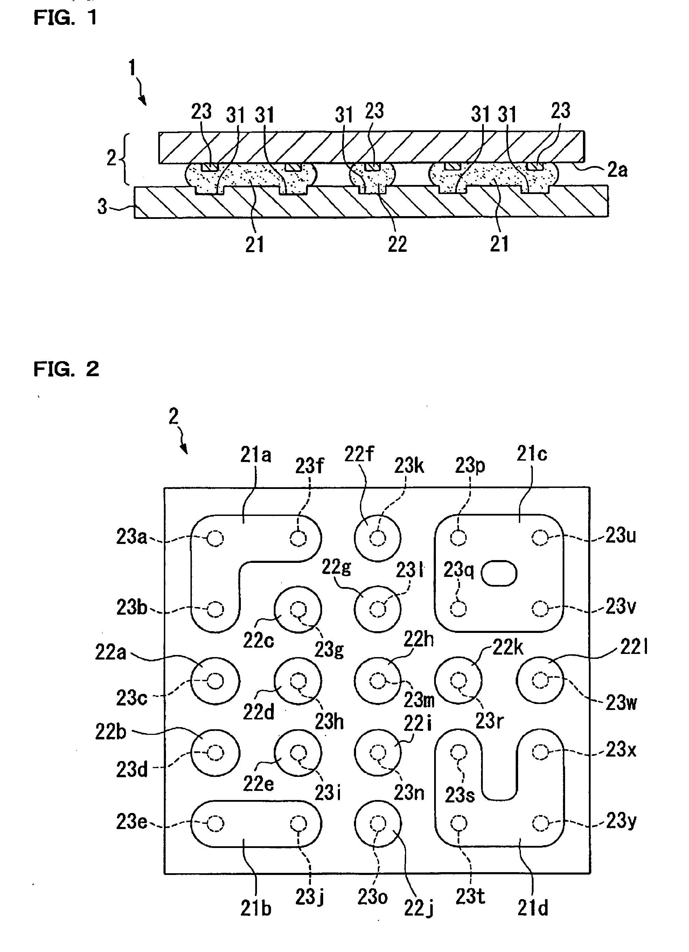

FIG. 1 is a side view of a semiconductor device 1 according to a first embodiment of the present invention. As shown in the figure, the semiconductor 1 according to the first embodiment includes a chip 2 and a circuit board 3 on which the chip 2 is mounted.

FIG. 2 is a view looking at the chip 2 from its underside. As shown in the figure, a relatively large connecting terminal 21 (a second terminal) and a relatively small connecting terminal 22 (a third terminal) are formed on an undersurface 2a of the chip 2. The chip 2 has an integrated circuit and a package packing the integrated circuit. A terminal 23 that is provided in a plural number and in array, the connecting terminal 21 and the connecting terminal 22 are coupled to the integrated circuit or the package. A size of each terminal 23 is substantially the same.

As shown in FIG. 2, the relatively large connecting terminal 21 (hereinafter called "large terminal 21") is electrically coupled to astride at least two terminals 23 out of the plurality. More particularly, a large terminal 21a located in upper left of FIG. 2 is formed astride terminals 23a, 23b and 23f, and a large terminal 21b located in lower left of FIG. 2 is formed so as to span terminals 23e and 23j. In the same manner, a large terminal 21c located in upper right of FIG. 2 is formed so as to lie across terminals 23p, 23q, 23u and 23v, and a large terminal 21d located in lower right of FIG. 2 is formed so as to span terminals 23s, 23t, 23x and 23y. In other words, in this embodiment, the large terminal 21 is provided on each comer of the rectangular undersurface 2a (a predetermined face) of the chip 2, and each of the large terminals 21a through 21d has a different shape.

Furthermore, as shown in FIG. 2, each relatively small connecting terminal 22 (hereinafter called "small terminal 22") is coupled to a single terminal 23 out of the plurality of the terminals 23. More particularly, a small terminal 22a is formed on a terminal 23c, a small terminal 22b is formed on 23d and a small terminal 22c is formed on 23g. In a similar way, a small terminal 22d is formed on a terminal 23h, a small terminal 22e is formed on 23i and a small terminal 22f is formed on 23k. In a same way, a small terminal 22g is formed on a terminal 23l, a small terminal 22h is formed on 23m and a small terminal 22i is formed on 23n. Moreover, a small terminal 22j is formed on a terminal 23o, a small terminal 22k is formed on 23r and a small terminal 221 is formed on 23w.

The large terminal 21 is formed so as to have a substantially same height from the undersurface 2a as that of the small terminal 22. Each large terminal 21 and the small terminal 22 is coupled to a connecting terminal 31 (a first terminal) formed on the circuit board 3. The connecting terminal 31 (a land) is provided in a plural number and in array in the same way as the terminal 23. Therefore, it is possible to electrically couple the large terminal 21 with astride at least two connecting terminals 31 out of the plurality formed on the circuit board 3. On the other hand, the small terminal 22 is coupled to a single connecting terminal 31 out of the plurality of the connecting terminals 31. These large terminals 21 and the small terminals 22 are made of a conductive metal such as solder.

According to such semiconductor device 1 of the first embodiment, the chip 2 has the large terminal 21 electrically coupled to astride at least two connecting terminals 31 out of the plurality. Therefore, a contact area of the chip 2 and the circuit board 3 becomes large and it can improve tolerance against the stress caused by the heat shock and the like. Accordingly, the semiconductor device 1 of the first embodiment can improve strength and it can prevent the large terminals 21 and the small terminals 22 of the chip 2 from coming off from the connecting terminals 31 of the circuit board 3.

Furthermore, according to the semiconductor device 1 of the first embodiment, the large terminal 21 is provided on each comer of the rectangular undersurface 2a (a predetermined face) of the chip 2. Therefore, it can protect the large terminal 21 or the small terminal 22, which is placed on the comers of the chip 2 where are most venerable to the stress caused by the heat shock, from being come off from the connecting terminal 31 of the circuit board 3.

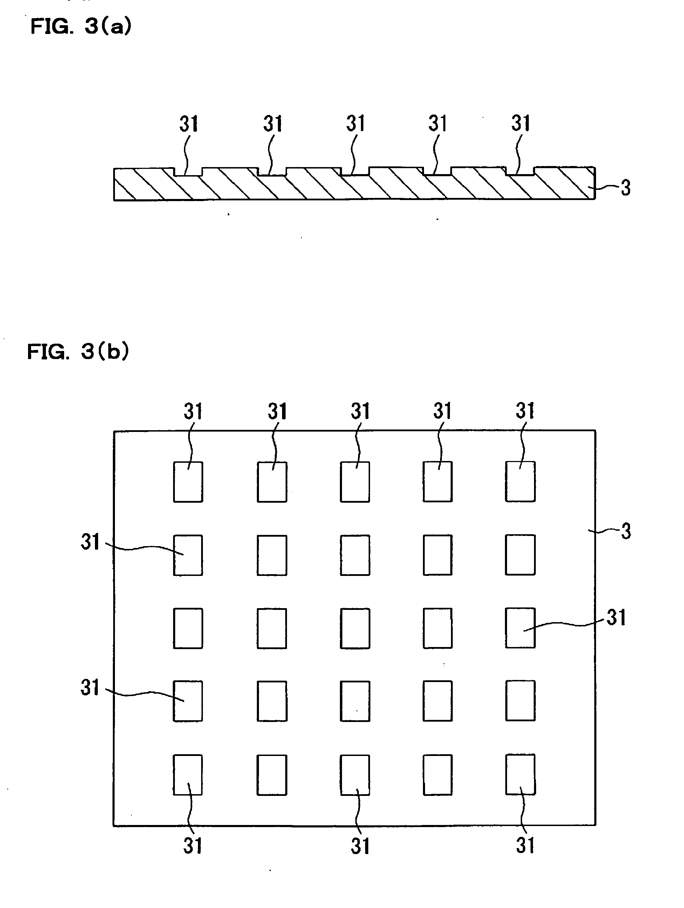

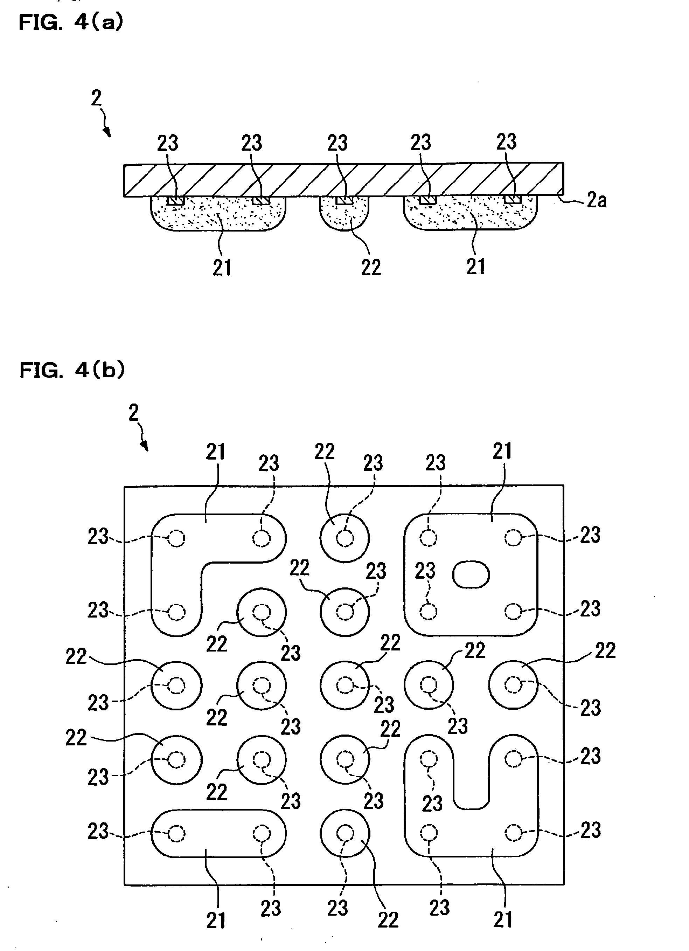

Next, a manufacturing method of the semiconductor device 1 according to the first embodiment will be described with reference to FIG. 3 and FIG. 4. FIG. 3a and FIG. 4a are side views and FIG. 3b and FIG. 4b are plain views. The manufacturing method of the semiconductor device 1 according to the first embodiment includes a step of forming the plurality of the connecting terminals 31 on the circuit board 3. The manufacturing method also includes a step of forming the large terminal 21 that is electrically connectable to astride at least two connecting terminals 31 out of the plurality of the connecting terminals 31 and the small terminal 22 that is coupled to a single connecting terminal 31 out of the plurality of the connecting terminals 31 on the chip 2. The manufacturing method also includes a step of electrically coupling the large terminal 21 and the small terminal 22 to the connecting terminal 31.

First, in the step of forming the plurality of the connecting terminals 31 on the circuit board 3, for example, the circuit board 3, which is formed such that a conducting layer and an insulating layer are piled up, is etched and the conducting layer is exposed by etching the insulating layer. In this way, the plurality of the connecting terminals 31 is formed as shown in FIG. 3.

Next, in the step of forming the large terminal 21 that is electrically connectable to astride at least two connecting terminals 31 out of the plurality of the connecting terminals 31 and the small terminal 22 that is coupled to a single connecting terminal 31 out of the plurality of the connecting terminals 31 on the chip 2, the conductive metal such as solder is provided and attached to the predetermined terminals 23a through 23y formed on the undersurface 2a of the chip 2. In this manner, the large terminal 21 that is electrically connectable to astride at least two terminals 23 out of the plurality of the terminals 23 and the small terminal 22 is coupled to the single connecting terminal 23 are formed. In this step, the large terminal 21 is formed so as to have a substantially same height from the undersurface 2a as that of the small terminal 22.

Then, in the step of electrically coupling the large terminal 21 and the small terminal 22 to the connecting terminal 31, the large terminal 21 and the small terminal 22 are coupled to the connecting terminals 31 of the circuit board 3 by putting the chip 2 on which the large terminal 21 and the small terminal 22 are formed on a predetermined position of the circuit board 3. Here, the chip 2 is easily mounted on the circuit board 3 because the large terminal 21 is formed so as to have the substantially same height from the undersurface 2a as that of the small terminal 22 in the previous step.

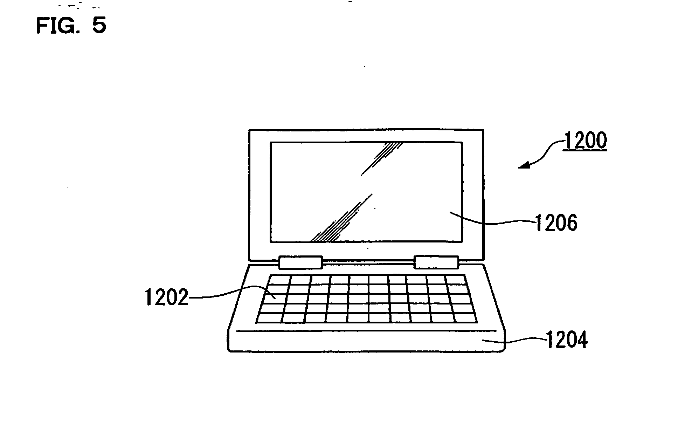

FIG. 5 is a perspective view showing an example of a portable information processing device (electronic equipment) such as a word processor and a personal computer having the semiconductor device 1 according to the first embodiment. In FIG. 5, reference numeral 1200 refers to an information processing device, reference numeral 1202 refers to an input unit such as a keyboard, reference numeral 1204 refers to a main body of the information processing device having the semiconductor device and reference numeral 1206 refers to a display unit of the above-mentioned electro-optical equipment.

Such information processing device 1200 has grate endurance against a heat stress caused by the heat shock and the like because it has the semiconductor device 1 according to the first embodiment of the present invention. Therefore, a reliability of the information processing device 1200 can be improved.

### (Second embodiment)

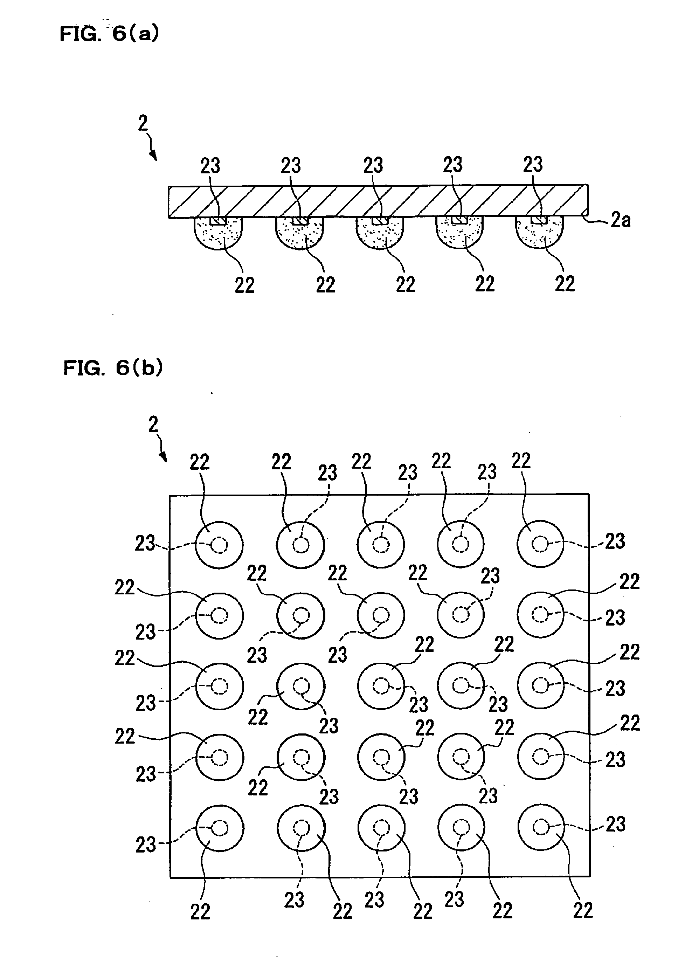

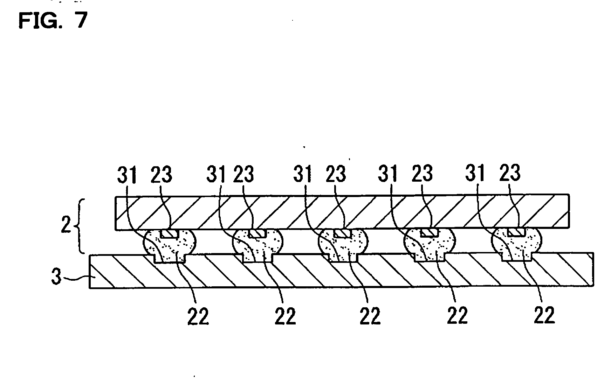

Next, a second embodiment of the present invention will be described with reference to FIG. 6 and FIG. 7. FIG. 6a is a side views and FIG. 6b is a plain view. In the second embodiment, the same structures as those of the first embodiment are given the identical numerals and those explanations will be omitted or simplified.

Difference between the first embodiment and the second embodiment is its manufacturing method. The manufacturing method of the semiconductor device 1 according to the second embodiment includes a step of forming the plurality of the connecting terminals 31 on the circuit board 3 and a step of forming a plurality of the small terminals 22 on the chip 2 such that each of the small terminals 22 is electrically connectable to each of the connecting terminals 31. The manufacturing method also includes a step of electrically coupling the small terminal 22 to the connecting terminal 31 and a step of forming the large terminal 21 that is electrically coupled to astride at least two connecting terminals 31 by filling the gaps between the small terminals 22 with a conductive material.

First, in the step of forming the plurality of the connecting terminals 31 on the circuit board 3, in the same way as the first embodiment, for example, the circuit board 3, which is formed such that the conducting layer and the insulating layer are piled up, is etched and the conducting layer is exposed by etching the insulating layer. Then, the plurality of the connecting terminals 31 is formed.

Next, in the step of forming a plurality of the small terminals 22 on the chip 2 such that each of the small terminals 22 is electrically connectable to each of the connecting terminals 31, the conductive metal such as solder is provided and attached to each of the terminals 23a through 23y formed on the undersurface 2a of the chip 2. In this way, as shown in FIG. 6, the small terminals 22 that are electrically connectable to the connecting terminals 31 are formed. In this step, it is preferred that each small terminal 22 is formed so as to have a substantially uniform height from the undersurface 2a of the chip 2.

After that, in the step of electrically coupling the small terminal 22 to the connecting terminal 31, each small terminal 22 is coupled to a respective connecting terminal 31 of the circuit board 3 as shown in FIG. 7 by putting the chip 2 on which the small terminals 22 are formed on a predetermined position of the circuit board 3. Here, if the small terminals 21 are formed so as to have the substantially uniform height from the undersurface 2a of the chip 2 in the previous step, the chip 2 can be easily mounted on the circuit board 3.

Then, in the step of forming the large terminal 21 that is electrically coupled to astride at least two connecting terminals 31 by filling the gaps between the small terminals 22 with a conductive material, a gap between predetermined small terminals 22 (small terminals positioned at the comers of the undersurface 2a of the chip 2) is filled with the conductive material such as solder. Consequently, the semiconductor device 1 shown in FIG. 1 is obtained.

As described above, the semiconductor device 1 may be manufactured by filling the gap between the small terminals 22 formed beforehand with the conductive material.

Although the semiconductor device, the manufacturing method thereof and electronic equipment according to the present invention have been fully described by way of example with reference to the accompanying drawings, it is obvious that the present invention is not limited to the above-described embodiments. It is to be understood that various changes and modifications will be apparent to those skilled in the art. Therefore, unless otherwise such changes and modifications depart from the scope of the present invention hereinafter defined, they should be construed as being included therein.

For example, in the above-described embodiment, the large terminal 21 is provided on each comer of the chip 2. However, not only the comers of the chip 2 but also an edge region of the chip 2 will get the stress caused by the heat shock. Therefore, in the present invention, the large terminals 21 may be formed across the edge region. More particularly, for example, the chip 2 may have the large terminal 21 that is formed so as to astride the above-mentioned terminal 22a and the terminal 23b.

### [Reference Numerals]

- 1:: SEMICONDUCTOR DEVICE
- 2:: CHIP
- 21:: LARGE TERMINAL (SECOND TERMINAL)
- 22:: SMALL TERMINAL (THIRD TERMINAL)
- 23:: TERMINAL
- 3:: CIRCUIT BOARD (SUBSTRATE)
- 31:: CONNECTING TERMINAL (FIRST TERMINAL)

## Claims

1. A semiconductor device, comprising:
a substrate on which a plurality of first terminals are formed; and
a chip having a second terminal electrically coupled to astride at least two first terminals out of the plurality of the first terminals.

2. The semiconductor device according to Claim 1, wherein the second terminal is provided in an edge region of a predetermined face of the chip.

3. The semiconductor device according to Claim 1, wherein the second terminal is provided at each comer of a predetermined rectangular face of the chip.

4. The semiconductor device according to any one of Claim 1 through 3, further comprising:
a third terminal that is smaller in size than that of the second terminal and provided in a plural number, wherein the second terminal is provided in a plural number on the predetermined face of the chip and the plurality of the second terminals and the plurality of the third terminals have a substantially same height from the predetermined face.

5. The semiconductor device according to any one of Claim 1 through 4, wherein the second terminal is provided in the plural number and each second terminal has a different shape.

6. The semiconductor device according to any one of Claim 1 through 5, wherein each of the plurality of the first terminals is substantially same in size.

7. A method of manufacturing a semiconductor device, comprising:
forming a plurality of first terminals on a substrate;
forming a second terminal on a chip so as to be electrically connectable to astride at least two first terminals out of the plurality of the first terminals; and
coupling the first terminal and the second terminal electrically.

8. A method of manufacturing a semiconductor device, comprising:
forming a plurality of first terminals on a substrate;
forming a plurality of third terminals on a chip such that each of the third terminals is electrically connectable to each of the first terminals;
coupling the first terminal and the third terminal electrically; and
forming a second terminal that is electrically coupled to astride at least two first terminals by filling a gap between the third terminals with a conductive material.

9. An electronic equipment, comprising the semiconductor device according to any one of Claim 1 through 6.
